# EUROPEAN PATENT APPLICATION

(11) **EP 4 790 855 A1**
(43) Date of publication of application: **12.08.2026**
(21) Application number: 25157064.4
(22) Date of filing: 11.02.2025
(51) Int. Cl.: H02B 1/28, H05K 7/14

(54) **HOUSING FOR HIGH-POWER CONVERTER CELLS WITH MULTI-LAYER INSULATION AND EXPLOSION SUPPRESSION**

(71) Applicant: Hitachi Energy Ltd, 8050 Zürich (CH)
(72) Inventor: NAWAZ, Muhammad, 19732 Bro (SE); AUGUSTIN, Tim, 72359 Västerås (SE); LIU, Bochen, 72461 Västerås (SE); SAND, Ulf, 72356 Västerås (SE)
(74) Representative: Zacco Sweden AB

(57) **Abstract**

Embodiments herein provide a housing (100) for high-power converter cells. The housing (100) comprises an enclosure (110) configured to accommodate two or more compartments (120). The housing further comprises at least one compartment (120) disposed within the enclosure (110), wherein the compartment (120) encloses at least one converter cell. The housing further comprises a particulate material (130) disposed within the at least one compartment (120). The particulate material (130) is pressure and shock-absorbing, humidity resistant, arc quenching, electrically insulative, and thermally dissipative, ensuring protection of the converter cell from mechanical stresses, electrical discharges, and thermal overloads during operation.

## Description

### TECHNICAL FIELD

The present disclosure generally relates to explosion-proof housing systems for high-power electronics. More particularly, it relates to a robust housing system for high-power converter cells that provide enhanced explosion containment, thermal dissipation, and electrical insulation.

### BACKGROUND

High-power converter cells are critical components in industrial applications and are typically composed of semiconductor switches, gate drive units, DC link capacitors, busbars, thermal management elements, and protection components. During continuous operation under high electrical and thermal stress, converter cells are prone to thermal fatigue, which can result in uncontrolled failures, including short-circuit faults or overload conditions. Such failures can lead to catastrophic explosions, particularly in designs where large amount of energy is stored within the converter cell. These explosions can cause significant damage to adjacent cells, surrounding equipment, and the environment due to the release of debris or ionized plasma generated during the explosion.

In configurations with multiple converter cells operating in close proximity, the explosion of a single cell can propagate to adjacent cells, triggering cascading failures and potentially leading to complete outage of a converter station. While conventional explosion-proof housing solutions, such as those using reinforced materials, seals, and bypass mechanisms, offer some protection, they often fall short of addressing the combined requirements of pressure shock absorption, thermal dissipation, and electrical insulation demanded by high-power converter cells.

Thus, there is a need for robust and reliable housing system that not only mitigates the risk of explosion but also provides enhanced thermal management, electrical isolation, and mechanical durability to ensure safe and reliable operation of high-power converter cells.

### SUMMARY

It is therefore an object of the present disclosure to provide an improved explosion-proof housing for high-power converter cells to mitigate, alleviate, or eliminate the above-mentioned drawbacks of presently known solutions.

This and other objects are achieved by means of a housing system, as defined in the appended claims. The term "exemplary" is in the present context to be understood as serving as an instance, example or illustration.

According to a first aspect of the present disclosure, a housing for high-power converter cells is provided. The housing comprises an enclosure configured to accommodate two or more compartments. The housing further comprises at least one compartment disposed within the enclosure, wherein the compartment encloses at least one converter cell. The housing further comprises a particulate material disposed within the at least one compartment, wherein the particulate material is pressure shock absorbing, humidity resistant, arc quenching, electrically insulative, and thermally dissipative.

Advantageously, the housing ensures that the particulate material absorbs pressure shocks, electrically isolates the converter cells, and dissipates heat effectively, thus preventing damage to adjacent cells and surrounding equipment.

In some embodiments, the enclosure is electrically grounded for controlled discharge of stray currents, and the compartment comprises an inner wall coated with an electrically insulating material that prevents electrical discharge between components.

Advantageously, this electrical insulation prevents inadvertent shorts or faults due to operational stress, to ensure safe operation.

In some embodiments, the housing further comprises an outer wall of the compartment surrounded by a protective layer comprising a polymeric or elastomeric material, wherein the protective layer is adapted to either allow permeable gas flow to the surrounding environment or to be non-permeable, and provides higher resistance to mechanical impacts, heat resistance, humidity resistance, and environmental degradation, while also contributing to the compressibility of the particulate material.

Advantageously, the protective layer ensures integrity of the housing, even under extreme conditions, while allowing safe gas flow and resistance to external damage.

In some embodiments, the the particulate material is selected from the group consisting of Alumina, *Al*₂*O*₃, Magnesia, *MgO,* Boron Nitride, *BN,* Aluminum Nitride, *AlN,* Zirconia, *ZrO₂,* Borides, Carbides, Nitrides, or Silicon Dioxide, *SiO*₂, and is electrically insulating, thermally dissipative, and further suppresses arcing, quenches explosions, mitigates combustion through integrated fire-extinguishing agents, and prevents the spread of debris or fragments to the surrounding environment.

Advantageously, the particulate material improves safety by suppressing explosions, mitigating fires, and containing debris within the housing, to prevent environmental contamination.

In some embodiments, the particulate material is provided in granular or powdered form, ensuring adequate packing density to enhance thermal dissipation and shock absorption.

Advantageously, the granular or powdered form improves the material's effectiveness in shock absorption and heat dissipation, thereby providing improved performance during high-stress operational conditions.

In some embodiments, the particulate material substantially fills the compartment's total volume to ensure optimal pressure and shock absorption, thermal dissipation, and electrical insulation.

Advantageously, this ensures that the entire volume is effectively utilized to enhance the housing's protective functions, thereby minimizing the risk of failure during operation.

In some embodiments, the particulate material is integrated with at least one water inlet and at least one water outlet pipe passing through the enclosure, one or more compartments, the inner wall of the compartment coated with an electrically insulating material, the outer wall of the compartment surrounded by a protective layer, and particulate material.

Advantageously, the water inlet and outlet integration improve the cooling and thermal management capabilities of the housing, to ensure safe operation under high thermal stress.

In some embodiments, the particulate material within the compartment provides a variable gas permeability distribution towards the inner wall of the compartment.

Advantageously, the variable gas permeability controls pressure build-up and improves safety during containment of explosion.

In some embodiments, the insulating material coating of the inner wall is adapted to provide higher electrical insulation and thermal stability.

Advantageously, the coating improves the housing's ability to prevent electrical faults while maintaining structural integrity under thermal stress.

In some embodiments, the protective layer surrounding the outer wall comprises a material that is compressible, heat resistant, resistant to oxidation and/or ozone, water, humidity, and possesses mechanical strength for enhancing the durability and functionality of the outer wall.

Advantageously, the protective layer improves the housing's resilience against environmental factors, thereby prolonging the service life while ensuring consistent performance.

In some embodiments, the housing comprises an enclosure that accommodates two or more compartments arranged modularly, to allow scalability for different power ratings and energy storage requirements.

Advantageously, this modular arrangement provides flexibility to adapt the housing to a variety of power systems while ensuring efficient use of space and resources.

In some embodiments, the outermost layer of the enclosure comprises a material that offers higher resistance to moisture ingress compared to its immediate adjacent layer, and/or improved insulation capabilities to protect against environmental exposure including temperature and humidity.

Advantageously, this improves the housing's durability and reliability in diverse operating environments, to ensure the protection of internal components from environmental degradation.

In some embodiments, the housing is of an arbitrary shape.

In some embodiments, the housing further comprises openings for bushing arrangements or connectors to interface with external components.

In some embodiments, the housing further comprises DC link capacitors mounted outside the enclosure, or optionally between the enclosure and the compartment.

In some embodiments, the one or more compartments enclose DC link capacitors and directly connect them to DC buses for integrated operation.

According to a second aspect of the present disclosure, a power converter arrangement is provided, comprising a housing as described above, a converter cell housed within the compartment, wherein the converter cell is electrically isolated by the particulate material, and a DC link capacitor connected to the converter cell, wherein the DC link capacitor is mounted either inside and/or outside the housing.

In some embodiments, the converter cell is connected to a DC bus through bushing arrangements or connectors provided in the openings of the housing.

In some embodiments, any of the above aspects may additionally have features identical with or corresponding to any of the various features as explained above for any of the other aspects.

Other advantages may be readily apparent to one having skill in the art. Certain embodiments may have some, or all of the recited advantages.

### BRIEF DESCRIPTION OF THE DRAWINGS

The foregoing will be apparent from the following more particular description of the example embodiments, as illustrated in the accompanying drawings in which like reference characters refer to the same parts throughout the different views. The drawings are not necessarily to scale, emphasis instead being placed upon illustrating the example embodiments. It should be understood that the figures represent only one possible exemplary shape, and variations in form and implementation are possible within the scope of the invention.
- FIG. 1: discloses a perspective view of the overall housing assembly, showing the enclosure and associated components;
- FIG. 2: is an exploded view of the housing, showing the enclosure, compartment, particulate material, and associated components;
- FIG. 3: is a cross-sectional view of a compartment, showing the inner wall coated with insulating material, the outer wall surrounded by protective layer, and the compartment filled with particulate material;
- FIG. 4: discloses a schematic view showing multiple layers of particulate material; and
- FIG. 5: discloses integrated water inlet and outlet pipes disposed within the particulate material;
- FIG. 6: discloses an opening configured to interface with external components, to enable electrical connections to and from the housing;
- FIG. 7: discloses DC link capacitors mounted externally and their electrical connection to DC buses; and
- FIG. 8: discloses a modular arrangement of the housing, where two or more compartments are arranged within the enclosure.

### DETAILED DESCRIPTION

Aspects of the present disclosure will be described more fully hereinafter with reference to the accompanying drawings. The apparatus disclosed herein can, however, be realized in many different forms and should not be construed as being limited to the aspects set forth herein. Like numbers in the drawings refer to like elements throughout.

The terminology used herein is for the purpose of describing particular aspects of the disclosure only and is not intended to limit the invention. It should be emphasized that the term "comprises/comprising" when used in this specification is taken to specify the presence of stated features, integers, steps, or components, but does not preclude the presence or addition of one or more other features, integers, steps, components, or groups thereof. As used herein, the singular forms "a", "an" and "the" are intended to include the plural forms as well, unless the context clearly indicates otherwise.

Energy storage systems, particularly those employed in high-power converter cells, face significant technical challenges in terms of safety, reliability, and adaptability. These systems are used in energy grids, industrial power systems and renewable energy applications, where robust solutions are essential to meet operational demands and withstand environmental factors.

Some challenges associated with such systems pertain to the risks posed by thermal runaway events, explosions, and other catastrophic events arising from high energy densities inherent in these systems. Conventional housing designs often fail to effectively contain pressure and dissipate energy during extreme conditions, resulting in uncontrolled damage to the system and surrounding infrastructure. Furthermore, the safety of personnel and adjacent equipment is critically dependent on the housing's ability to show explosion proof characteristics under the extreme conditions.

Environmental exposure introduces further complexities that compromise the performance and durability of energy storage systems. Adverse factors such as moisture ingress, temperature variations, and humidity contribute to the degradation of system components. This leads to reduced operational efficiency, shortened service life, and increased maintenance requirements. Existing housing solutions typically provide insufficient protection against such environmental stress, thereby compromising the system's operational reliability in the long term.

Scalability is an additional technical challenge, as energy demands vary significantly across applications. From small scale renewable installations to large industrial systems, housing solutions must accommodate diverse power ratings and energy storage requirements. Conventional designs often lack the modularity necessary to provide such scalability without extensive redesigns or added complexity.

Thermal management is yet another critical consideration in high-power converter cells, which generate substantial heat during operation. Inefficient dissipation of heat leads to overheating, performance degradation, and even catastrophic system failures. Existing housing solutions often fail to adequately integrate thermal management systems, resulting in suboptimal heat transfer and increased vulnerability to thermal stresses.

Embodiments herein provide an explosion proof housing system to address the above challenges in high-power energy storage systems by containing and dissipating energy during extreme events, such as thermal runaway or explosions, through a multi-layered arrangement with energy absorbing materials; mitigating environmental stresses, including moisture ingress, temperature fluctuations, and humidity, using advanced materials; providing modularity and scalability via multiple compartments within an enclosure; improving thermal management with integrated cooling mechanisms, such as strategically positioned cooling pipes; and incorporating openings adapted to interface with external components for reliable electrical and mechanical integration.

Accordingly, the present invention offers a robust and versatile housing solution for high-power energy storage systems. By addressing the aforementioned technical challenges, the invention ensures enhanced operational safety, environmental resilience, and scalability while supporting the diverse requirements of modern energy storage applications.

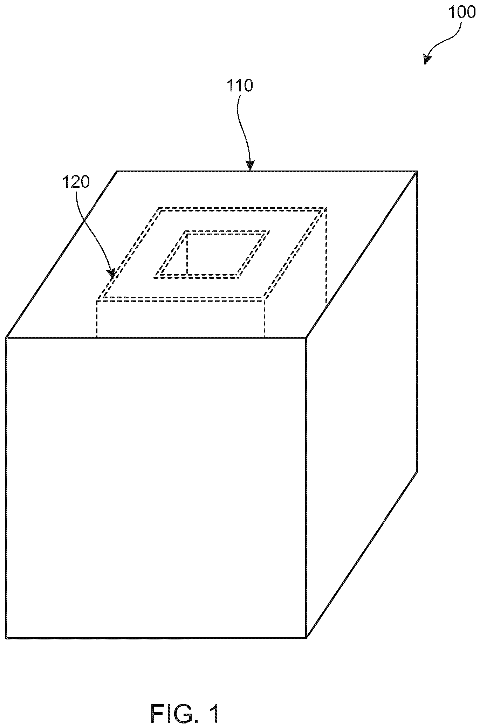

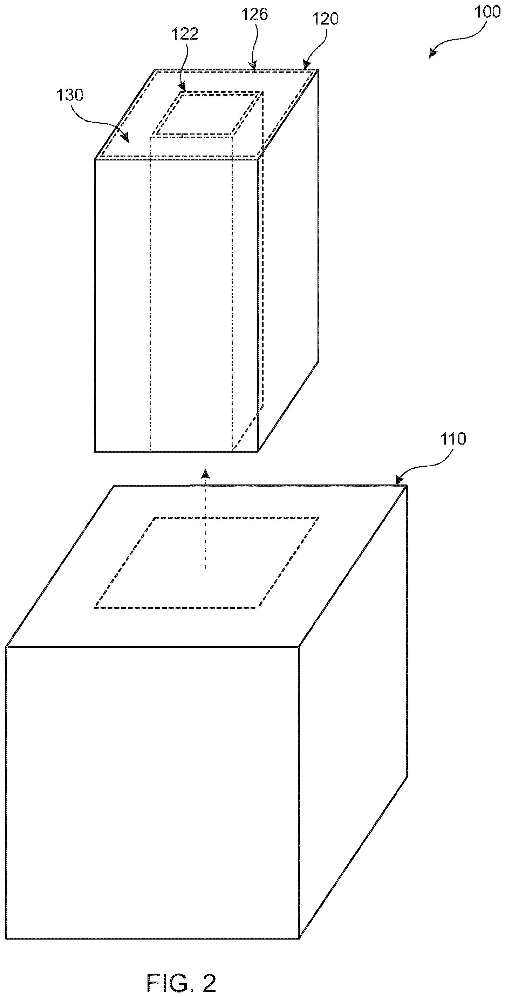

FIG. 1 discloses a perspective view of a housing 100 for high-power converter cells according to an embodiment of the present disclosure. The housing 100 comprises an enclosure 110 adapted to accommodate two or more compartments 120. At least one compartment 120 is disposed within the enclosure 110, enclosing at least one converter cell. Within compartment 120, a particulate material 130 is disposed. The particulate material 130 serves multiple functions, being pressure and shock absorbing, humidity resistant, arc quenching, electrically insulative, and thermally dissipative, thereby contributing to the housing's 100 ability to manage extreme conditions such as thermal runaway or explosions, while enhancing the overall safety and durability of the high-power converter cells. These features are further detailed in Fig. 2, which illustrates an exploded view of the housing 100, showing the arrangement and interconnection of the components.

In some examples, the housing 100 may include an enclosure 110 adapted to house multiple compartments 120, where each compartment 120 is adapted to enclose at least one converter cell.

FIG. 2 illustrates an exploded view of the housing 100 for high-power converter cells, showing the arrangement of the enclosure 110, inner wall 122, and outer wall 126 of the compartment 120. These components of the housing 100 are arranged to provide robust protection and operational functionality under extreme conditions.

The enclosure 110 forms the outer structure of the housing 100, providing mechanical strength, environmental sealing, and resistance to external impacts. Within the enclosure 110, at least one compartment 120 is disposed. The compartment 120 is structured to securely enclose at least one converter cell. Preferably, in an operative position, the enclosure (110) is electrically grounded to provide controlled discharge of stary currents, to enhance electrical safety and mitigate risk of unintended potential differences. However, the enclosure (110) may be implemented without electrical grounding depending on specific application requirements.

The compartment 120 includes an inner wall 122 coated with an electrically insulating material 124. This coating 124 prevents electrical discharge with the components housed within the compartment 120, and ensures thermal stability under high voltage and high temperature operating conditions.

The external boundaries of the compartment 120 are defined by the outer wall 126, which is surrounded by a protective layer 128. The protective layer 128 is composed of materials such as polymeric or elastomeric compounds that provide resilience against mechanical impacts, environmental degradation, and temperature variations. Additionally, the protective layer 128 is adapted to either allow permeable gas flow to the surrounding environment or to be non-permeable, ensuring effective pressure equalization while maintaining structural integrity. It also offers heat resistance, humidity resistance, and environmental degradation, while also contributing to the compressibility of the particulate material (130).

Within the compartment 120, particulate material 130 is disposed between the inner wall 122 and outer wall 126. The particulate material 130 provides pressure and shock absorption, electrical insulation, and thermal dissipation. It is strategically distributed within the compartment 120 to provide uniform coverage to mitigate risks associated with thermal runaway, arcing, and potential explosions.

The exploded view in Fig. 2 illustrates the alignment and interconnection of these components. The inner wall 122 coated with insulating material 124 ensures electrical safety within the compartment 120, while the outer wall 126 with its protective layer 128 safeguards the compartment 120 from external stresses. Together, Figs. 1 and 2 disclose the housing 100 as a robust, thermally efficient, and safe enclosure for high-power converter cells.

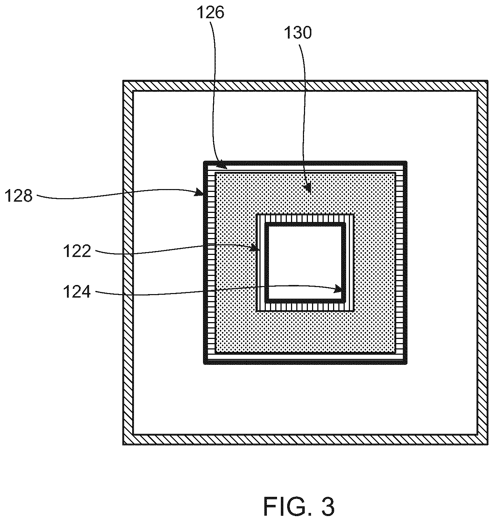

Fig. 3 is a cross-sectional view of the compartment 120 within the housing 100, illustrating the structural and material composition of the inner wall 122, outer wall 126, and the particulate material 130 packed between them. These components work together to provide comprehensive protection and functionality. These components, previously introduced in Fig. 2, are shown in greater detail in Fig. 3. While FIG. 2 emphasizes the exploded view of the entire housing 100, FIG. 3 focuses on the internal structure and functional arrangement of the compartment 120 within the housing 100. These figures illustrate complementary aspects of various embodiments described in the claims.

In some embodiments, the inner wall 122 of the compartment 120 is coated with an electrically insulating material 124. This coating 124 prevents electrical discharge between components housed within the compartment, to improve the safety and reliability of the housing 100. The insulating material 124 provides high electrical insulation and thermal stability, to ensure that the inner wall 122 withstands various operational stresses without compromising its insulating properties.

In some embodiments, the insulating material 124 coating of the inner wall 122 is adapted to provide higher electrical insulation and thermal stability.

In an example, the insulating material 124 coating of the inner wall 122 may be adapted to provide a significantly higher level of electrical insulation compared to the adjacent particulate material 130. While the particulate material 130 may inherently offer some level of insulation, it primarily serves as a thermal barrier and shock-absorbing medium. In contrast, the electrically insulating coating 124 on the inner wall 122 provides superior dielectric strength, which is critical for preventing electrical arcing or discharge within high-power environments.

For instance, the insulating material 124 may comprise epoxy resin, which provides high dielectric strength and thermal stability. This ensures that the inner wall 122 can withstand voltage spikes and high temperature during operation without compromising its insulating properties. Compared to the particulate material 130, which may consist of materials like sand or granular ceramic that have lower electrical resistance, the insulating layer 124 on the inner wall 122 achieves a much higher electrical breakdown voltage. This difference ensures that any potential leakage current or voltage spike is effectively contained by the inner wall 122, protecting both the housed components and the structural integrity of the compartment 120.

In addition to its electrical insulation properties, the coating 124 also provides thermal stability by maintaining its performance across a wide temperature range. This ensures that the inner wall 122 remains effective in environments subject to significant thermal cycling or high operating temperatures.

In some embodiments, the outer wall 126 of the compartment 120 is enveloped by a protective layer 128. The protective layer 128 is composed of materials such as polymeric or elastomeric compounds that provide resilience against mechanical impacts, environmental degradation, and temperature variations. Additionally, the protective layer 128 allows permeable gas flow to the surrounding environment, to ensure effective pressure equalization while maintaining structural integrity.

In some embodiments, the protective layer 128 surrounding the outer wall 126 comprises a material that is compressible, heat resistant, resistant to oxidation and/or ozone, water, humidity, and possesses mechanical strength for enhancing the durability and functionality of the outer wall 126.

In an example, the protective layer 128 may be composed of silicone-based elastomers, which provide excellent resilience to mechanical shocks and environmental conditions such as humidity and extreme temperatures.

In another example, the protective layer 128 absorbs impacts from the debris or mechanical stress while allowing controlled gas permeability for pressure equalization.

Within the compartment 120, particulate material 130 is disposed, between the inner wall 122 and outer wall 126. The particulate material 130 serves multiple functions, including pressure and shock absorption, electrical insulation, and thermal dissipation. It is strategically distributed within the compartment 120 to provide uniform coverage, for mitigating risks associated with thermal runaway, arcing, and potential explosions.

In some embodiments, the compartment 120 is filled with particulate material 130, which is selected from the group consisting of Alumina, *Al*₂*O*₃, Magnesia, *MgO,* Boron Nitride, *BN,* Aluminum Nitride, *AlN,* Zirconia, *ZrO₂,* Borides, Carbides, Nitrides, or Silicon Dioxide, *SiO*₂, and is electrically insulating, thermally dissipative, and capable of suppressing arcing, quenching explosions, mitigating combustion through integrated fire-extinguishing agents, and preventing the spread of debris or fragments to the surrounding environment.

In an example, the particulate material 130 may comprise granular Boron Nitride, *BN,* which is thermally conductive and electrically insulating. This material improves heat dissipation generated during high power operation, reducing the risk of thermal runaway, and mitigating the risk of arcing.

In another example, the particulate material 130 may include integrated fire-extinguishing agents, such as magnesium hydroxide *Mg*(*OH*)₂*,* which release water vapor at high temperatures to suppress combustion. This material prevents the spread of flames and debris to surrounding areas.

In another example, the particulate material 130 may include hydrated salts, such as sodium bicarbonate or potassium carbonate, which decompose at high temperatures to release inert gases. These gases displace oxygen and prevent combustion, thereby adding another layer of safety to the housing.

In another example, the particulate material 130 may include Zirconia, *ZrO₂,* or Carbides, which provide excellent shock absorption and pressure resistance. These materials ensure that the housing 100 withstands mechanical impacts or vibrations without compromising its structural integrity.

In an example implementation, the strategic distribution of the particulate material 130 may involve optimizing its density and arrangement within the compartment 120 to ensure consistent thermal dissipation, shock absorption, and insulation. For example, the material may be packed more densely near areas of high thermal load, such as regions in close proximity to the converter cell's heat-generating components.

In some embodiments, the particulate material 130 is provided in granular or powdered form, ensuring adequate packing density to enhance thermal dissipation and shock absorption.

In an example, the particulate material 130 may comprise granular Alumina, *Al₂O₃,* with a high thermal conductivity. This granular structure allows for efficient heat transfer away from the converter cell, reducing hotspots and maintaining uniform temperature distribution within the compartment 120.

In another example, the particulate material 130 may include powdered Boron Nitride, *BN,* which has a fine particle size distribution and a thermal conductivity. The powdered form enables high packing density, which not only enhances thermal dissipation but also provides a cushioning effect to absorb shocks or vibrations.

In another example, the particulate material 130 may include granular Aluminum Nitride, *AlN,* mixed with fine Zirconia, *ZrO₂,* powder. The *AlN* granules dissipate heat from high-temperature regions, while the *ZrO*₂ powder absorbs mechanical shocks, thereby allowing the housing 100 to withstand operational stress.

In some embodiments, the particulate material 130 substantially fills the compartment's 120 total volume to ensure optimal pressure and shock absorption, thermal dissipation, and electrical insulation.

In some examples, the compartment 120 may be entirely filled with fine-grain Aluminum Nitride, *AlN,* which ensures high thermal dissipation due to its thermal conductivity and evenly distributes internal pressure. This prevents localized stress on the inner and outer walls, enhancing the structural integrity of the housing 100.

In some examples, the particulate material 130 may include granular Zirconia, *ZrO*₂*.* By filling the total volume of the compartment 120, the *ZrO*₂ granules provide uniform shock absorption, effectively protecting sensitive components from mechanical impacts during operation or transportation.

In some examples, combination of granular Magnesia, *MgO,* and powdered Boron Nitride, *BN,* may be used to fill the compartment 120 entirely. The *MgO* granules maintain the structural stability under high pressure, while the powdered *BN* fills smaller gaps to improve both thermal dissipation and electrical insulation.

In some embodiments, the particulate material 130 within the compartment 120 provides a variable gas permeability distribution towards the inner wall 122 of the compartment 120, to improve the compartment's 120 ability to manage internal pressures and thermal loads.

In an example, the particulate material 130 is composed of a gradient of granular sizes, with finer particles positioned closer to the inner wall 122 and coarser particles nearer to the outer wall 126. This distribution allows gases generated during thermal events to diffuse more effectively, reducing localized pressure build-up near the inner wall 122 while maintaining structural integrity.

In another example, the particulate material 130 includes porous Boron Nitride, *BN,* granules closer to the inner wall 122 for enhanced gas absorption, while the outer regions consist of solid Aluminum Nitride, *AlN,* particles for improved thermal conductivity. This configuration balances the compartment's 120 ability to dissipate heat and manage gas pressures simultaneously.

In another example, the particulate material 130 may be designed with compressible elastomeric particles near the inner wall 122 to allow temporary expansion and contraction during pressure changes. This design reduces mechanical stress on the compartment 120 while facilitating effective thermal load management.

Therefore, the combination of the electrically insulating inner wall 122, the protective outer wall 126, and the particulate material 130 ensures that the compartment 120 within the housing 100 handles electrical, thermal, and mechanical stresses, to provide a robust and reliable housing solution for high-power converter cells.

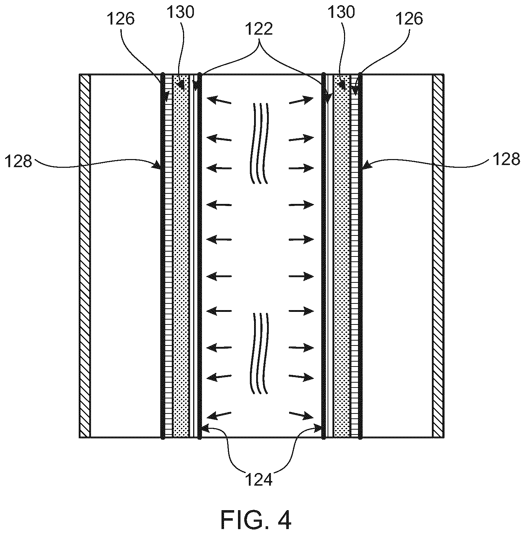

FIG. 4 discloses a sectional view of the compartment 120 within the housing 100, providing an alternate perspective on its structural and material configuration previously described in Fig. 3. This figure emphasizes the interplay between the inner wall 122, coated with an electrically insulating material 124, the outer wall 126 with protective coating 128, and the particulate material 130 disposed between the walls. While FIG. 3 offers a cross-sectional view focused on material properties and composition, FIG. 4 visually emphasizes the functional interactions during dynamic events such as thermal escalation or explosions (represented with directional arrows in FIG. 4). Together, FIGS. 3 and 4 provide complementary perspectives on the operational integrity of the housing 100 under stress.

The inner wall 122, coated with the insulating material 124, serves as a primary containment barrier that ensures the safety and reliability of the housing 100. The insulating material 124 prevents electrical discharge and short circuits while also providing enhanced thermal stability under operational and extreme conditions. This layer is adapted to remain structurally intact, even under high thermal and mechanical stress, thereby preventing breach or failure.

During an internal event, such as an explosion or thermal escalation (represented by directional arrows in FIG. 4), the following mechanisms occur within the compartment 120:
Pressure Absorption and Containment: The particulate material 130 situated between the inner wall 122 and outer wall 126 absorbs the rapid pressure increase caused by such events. This material is adapted to distribute the pressure uniformly, minimizing the risk of stress concentrations on any specific area of the inner wall 122. The coating of electrically insulating material 124 on the inner wall 122 reinforces its ability to withstand these pressures, preventing rupture or collapse, and ensuring the containment of high-pressure debris within the compartment 120.

Shock Damping: The particulate material 130 exhibits shock-absorbing properties, acting as a buffer against mechanical impacts and explosive forces. As shown in FIG. 4, the shock waves generated during an explosion are mitigated through the particulate material's inherent capacity to dissipate energy. This prevents mechanical damage to the housing 100 and adjacent components, thereby ensuring operational safety and structural integrity.

Thermal Dissipation: Heat generated during an explosion or high-power operation is efficiently absorbed and dissipated by the particulate material 130. Materials such as granular Boron Nitride, *BN,* or Aluminum Nitride, *AlN,* as described previously in description of Fig. 3, improve thermal conductivity by transferring heat away from the inner wall 122 and the surrounding high-power converter cells. This ensures that localized overheating is mitigated, thereby reducing the likelihood of cascading failures within the housing 100.

Gas Permeability and Pressure Equalization: The particulate material 130 provides controlled gas diffusion, enabling pressure equalization within the compartment 120 while maintaining structural integrity. For example, the granular structure of the material allows gases generated during thermal events to permeate gradually, reducing localized pressure build-up near the inner wall 122. This mitigates the risk of explosive force propagation to adjacent equipment or external environments.

Mitigation of Debris and Combustion: The particulate material 130 also acts as a containment medium for debris or fragments produced during an explosion. The particulate material 130 may incorporate integrated fire-extinguishing agents, such as magnesium hydroxide, *Mg*(*OH*)₂*,* or hydrated salts, which release inert gases or water vapor at high temperatures. This functionality not only suppresses combustion but also prevents the spread of flames to other compartments or areas surrounding the housing 100.

Dynamic Interactions within Layers: The insulating material 124 coating the inner wall 122 enhances the wall's ability to withstand dynamic forces resulting from rapid thermal and pressure changes.

Meanwhile, the particulate material 130 creates a synergistic interaction by absorbing and redirecting these forces to protect the inner wall 122 and the converter cells housed within.

This sectional representation in FIG. 4 further illustrates how the inner wall 122, the insulating material 124, the particulate material 130, and the outer wall 126 interact cohesively to manage extreme electrical, thermal, and mechanical stresses. For brevity, the details described for FIG. 3 are not repeated here, as the sectional view merely provides a different visual perspective of the same arrangement.

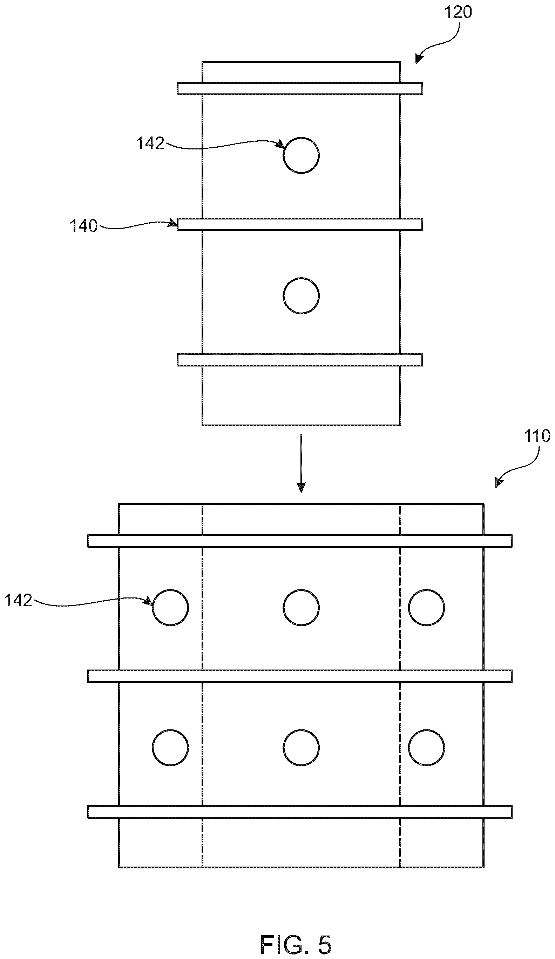

FIG. 5 illustrates a sectional view of housing 100, disclosing the integration of at least one water inlet 142 and at least one water outlet pipe 140 traversing the enclosure 110 and one or more compartments 120. The water inlet 142 and water outlet 140 are embedded within the particulate material 130 and extend across the length of the compartment 120.

The particulate material 130, as illustrated in FIG. 3, plays a dual role in the cooling system illustrated in FIG. 5. Its high thermal conductivity ensures efficient heat transfer to the water circulating through the water inlet 142 and outlet pipe 140, while its granular structure allows uniform dissipation of thermal energy, preventing localized hot spots within the compartment 120. Similarly, FIG. 4 emphasizes the shock absorption properties of the particulate material 130 during extreme events, such as explosions or rapid pressure changes. These shock-damping capabilities ensure the structural integrity of the embedded cooling pipes, protecting them from mechanical stress and maintaining uninterrupted coolant flow. Together, the functionalities depicted in FIG. 3 and FIG. 4 illustrate the synergy between heat management and structural stability, which are integral to the efficient operation of the cooling system shown in FIG. 5.

In some embodiments, the particulate material 130 is integrated with at least one water inlet 142 and at least one water outlet pipe 140 passing through the enclosure 110, one or more compartments 120, the inner wall 122 of the compartment 120 coated with an electrically insulating material 124, the outer wall 126 of the compartment 120 surrounded by a protective layer 128, and particulate material 130. This integration allows for efficient cooling and temperature regulation within the compartment.

In an example, the water inlet 142 and outlet pipe 140 are configured to circulate deionized water through a network of embedded channels within the particulate material 130. The deionized water flows through these channels, absorbing heat generated by the high-power converter cells. The particulate material 130, such as granular Aluminium Nitride, *AlN,* enhances thermal conductivity, ensuring that heat is uniformly transferred to the circulating water for efficient dissipation.

In another example, the water inlet 142 and outlet pipe 140 may be integrated with a closed-loop cooling system. The particulate material 130, such as Zirconia, *ZrO₂,* granules, surrounds the cooling pipes, ensuring that localized hot spots within the compartment 120 are quickly dissipated. This configuration minimizes the risk of overheating and thermal runaway.

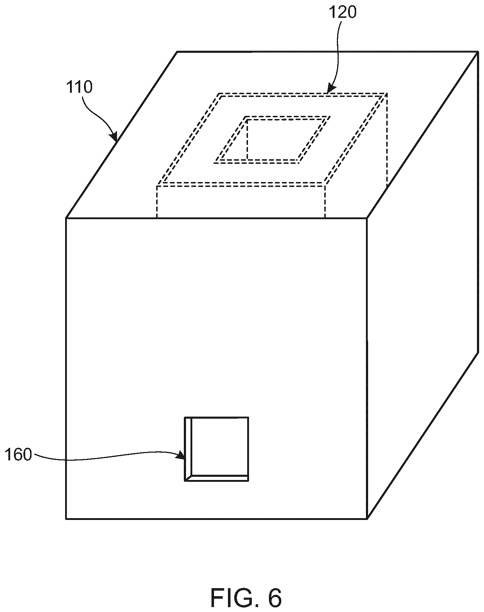

Fig. 6 discloses an opening 160 in the housing 100, designed to interface with external components, enabling electrical connections to and from the housing 100.

In some embodiments, the housing (100) is of an arbitrary shape, which allows flexibility to accommodate various spatial constraints, installation requirements, and thermal management considerations. The shape of the housing (100) is not limited to a specific geometric configuration and may be adapted based on structural, mechanical, or electrical integration needs, while maintaining its functional properties, including the enclosure (110) and protection of converter cells, while providing effective heat dissipation, arc quenching, and humidity resistance.

In some embodiments, the housing 100 comprises openings 160 configured to accommodate bushing arrangements or connectors, allowing for reliable electrical interfacing with external systems.

In an example, the housing 100 may include an opening 160 that accommodates both AC and DC power lines, allowing the housing to interface with different electrical sources or systems.

In another example, the opening 160 may be equipped with insulating materials to maintain electrical isolation and prevent short circuits. These insulating layers ensure safety and reliability when interfacing with high-power systems.

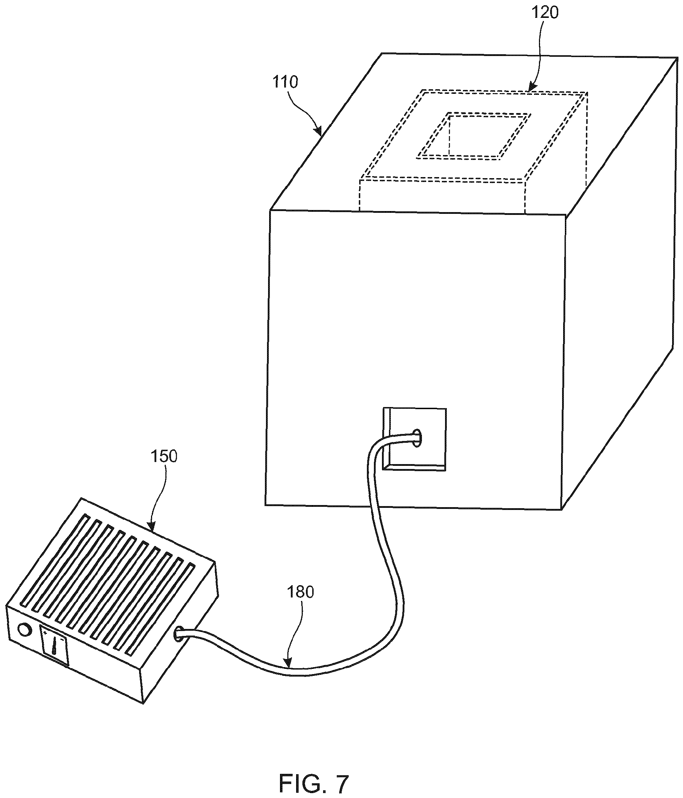

The opening 160 provide a pathway for connecting the DC link capacitors 150 (described in FIG. 7) and the internal DC buses 180, as well as other components such as converter cells housed within the compartments 120.

Therefore, the opening 160 provides the necessary flexibility for interfacing with a variety of external systems, to support the housing's 100 applicability across diverse industrial and high-power applications.

Fig. 7 discloses DC link capacitors 150 mounted externally to the housing 100, and their electrical connection to the DC buses 180 for integrated operation. This configuration provides improved thermal management, scalability, and ease of maintenance, ensuring reliable power delivery to high-power converter cells.

In some embodiments, the DC link capacitors 150 are mounted outside the enclosure 110. This arrangement enables the capacitors to stabilize the power supply to the high-power converter cells housed within the compartments 120, improving the overall efficiency and operational stability.

In an example, the DC link capacitors 150 are positioned outside the enclosure 110 of the housing 100, while still maintaining electrical interconnection to the internal DC buses 180.

In another example, the external placement of the DC link capacitors 150 allows for easier maintenance and cooling, as these components typically generate significant heat during operation. By positioning them outside the housing 100, the thermal load within the housing is reduced, and the capacitors can be more effectively cooled by external air or dedicated cooling systems.

In another example, the electrical connection between the DC link capacitors 150 and the internal DC buses 180 is achieved via connectors, that may handle high voltage and high current. This ensures that the capacitors 150 efficiently filter and smooth the DC power supplied to the converter cells. The capacitors serve to buffer voltage spikes, stabilize fluctuations in power delivery, and mitigate any noise or disturbances in the DC bus lines.

In some examples, the DC link capacitors 150 are housed in a separate enclosure or housing located adjacent to the main housing 100. This external arrangement allows for modular integration with the high-power converter system, where the capacitors 150 can be added, removed, or replaced as needed to meet specific operational requirements.

Alternatively, the DC link capacitors 150 may be located on the same structural support frame as the housing 100 but mounted externally and connected via insulated high-current cables to the DC buses 180. This setup allows for flexibility in system design, as the location and configuration of the capacitors 150 can be adjusted based on space constraints, thermal considerations, and electrical load requirements.

Advantageously, the integration of external DC link capacitors 150 externally with the housing 100 helps to reduce the overall footprint of the housing while improving the electrical performance of the converter cells. This arrangement efficiently manages power delivery, mitigates potential risks from electrical spikes, and maintains consistent operation even under heavy load conditions.

In some embodiments, the DC link capacitors 150 may be mounted between the enclosure 110 and the compartment 120. For example, this intermediate placement can balance thermal management and electrical integration while maintaining compact system dimensions.

In some embodiments, the one or more compartments 120 enclose DC link capacitors 150 and directly connect them to DC buses 180 for integrated operation within the housing 100.

The housing 100 described in Figs. 1-7 is further adapted to support a power converter arrangement configured for high-power applications. This arrangement integrates the housing 100 with: a converter cell disposed within the compartment 120, wherein the converter cell is electrically isolated by the particulate material 130, as illustrated in Fig. 3. The particulate material 130 provides effective insulation and thermal dissipation, ensuring reliable operation of the converter cell under high-power conditions; a DC link capacitor 150 mounted either internally or externally with respect to the housing 100, as disclosed in Fig. 7.

In some embodiments, the converter cell is connected to a DC bus 180 through bushing arrangements or connectors provided in the openings 160 of the housing 100.

In some examples, the DC link capacitor 150 is electrically connected to the converter cell and is configured to stabilize power delivery by filtering voltage fluctuations, mitigating electrical noise, and buffering voltage spikes; and electrical connections between the converter cell and the DC buses 180, facilitated through openings 160 in the housing 100, as illustrated in Fig. 6. These openings 160 are adapted to accommodate high-voltage connectors or bushing arrangements, thereby ensuring a secure and efficient electrical interface.

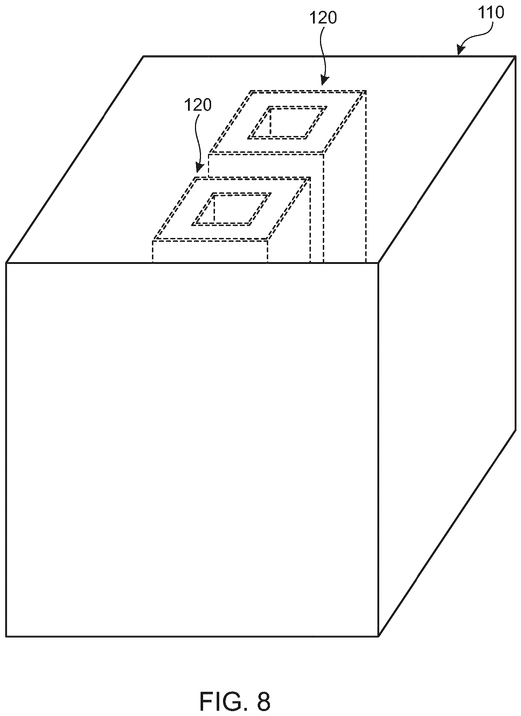

In some examples, the power converter arrangement incorporates a modular design, as illustrated in Fig. 8, allowing for scalability to meet diverse operational requirements. For example, the enclosure 110 may house multiple compartments 120, each accommodating a separate converter cell. These compartments 120 may be interconnected to form a modular power conversion system capable of scaling in capacity and functionality based on the application.

FIG. 8 discloses a modular arrangement of the housing 100, wherein two or more compartments 120 are arranged within the enclosure 110, providing scalability and flexible system configurations.

As illustrated in Fig. 8, the housing 100 is adapted to accommodate multiple compartments 120, each configured to house individual components or subsystems, such as high-power converter cells, DC link capacitors, cooling assemblies, or other associated equipment. These compartments are structured to operate independently or in combination, allowing the housing 100 to be scaled to meet varying system requirements.

In some examples, for applications requiring higher power output, additional compartments 120 may be incorporated within the enclosure 110 without the need to redesign the housing 100 entirely. This modularity allows the arrangement to be expanded or reconfigured by adding or removing compartments, providing a highly adaptable solution for different operational needs.

Each compartment 120 is isolated to ensure the segregation of critical components, thereby enhancing safety, thermal management, and overall reliability. For instance, compartments housing sensitive electronic components can be thermally insulated from those containing heat-generating components, ensuring efficient operation without thermal interference.

This modular arrangement also supports a plug-and-play design, where compartments 120 are preassembled with their respective components and later integrated into the enclosure 110. This approach simplifies installation, reduces downtime during upgrades or maintenance, and ensures consistency in manufacturing.

In a preferred embodiment, the housing 100 may comprise a set of three compartments 120, with each compartment connected to a common DC bus 180 or other shared infrastructure, such as cooling pipes, communication interfaces, or power distribution systems. This setup allows the compartments to function as a cohesive unit while maintaining the flexibility to replace or upgrade individual compartments as needed.

Therefore, the modular configuration as disclosed in FIG. 8 provides a scalable, adaptable, and cost-efficient solution for housing high-power components, ensuring flexibility and longevity in meeting diverse operational requirements.

The foregoing description of the specific embodiments will so fully reveal the general nature of the embodiments herein that others can, by applying current knowledge, readily modify and/or adapt for various applications such specific embodiments without departing from the generic concept. Therefore, such adaptations and modifications should and are intended to be comprehended within the meaning and range of equivalents of the disclosed embodiments. It is to be understood that the phraseology or terminology employed herein is for the purpose of description and not of limitation. Therefore, while the embodiments herein have been described in terms of preferred embodiments, those skilled in the art will recognize that the embodiments herein can be practiced with modification within the scope of the disclosure.

## Claims

1. A housing (100) for high-power converter cells, comprising:
- an enclosure (110) configured to accommodate two or more compartments (120);
- at least one compartment (120) disposed within the enclosure (110), wherein the compartment (120) encloses at least one converter cell; and
- a particulate material (130) disposed within the at least one compartment (120), wherein the particulate material (130) is pressure shock absorbing, humidity resistant, arc quenching, electrically insulative, and thermally dissipative.

2. The housing (100) according to claim 1, wherein the enclosure (110) is electrically grounded for controlled discharge of stray currents, and the compartment (120) comprises an inner wall (122) coated with an electrically insulating material (124) that prevents electrical discharge between components.

3. The housing (100) according to claim 1, further comprising an outer wall (126) of the compartment (120) surrounded by a protective layer (128) comprising a polymeric or elastomeric material, wherein the protective layer (128) is adapted to either allow permeable gas flow to the surrounding environment or to be non-permeable, and provide-higher resistance to mechanical impacts, heat resistance, humidity resistance, and environmental degradation, while also contributing to the compressibility of the particulate material (130).

4. The housing (100) according to claim 1, wherein the particulate material (130) is selected from the group consisting of Alumina, *Al*₂*O*₃*,* Magnesia, *MgO,* Boron Nitride, *BN,* Aluminum Nitride, *AlN,* Zirconia, *ZrO₂,* Borides, Carbides, Nitrides, or Silicon Dioxide, *SiO*₂, and is electrically insulating, thermally dissipative, and further suppresses arcing, quenches explosions, mitigates combustion through integrated fire-extinguishing agents, and prevents the spread of debris or fragments to the surrounding environment.

5. The housing (100) according to any of the preceding claims, wherein the particulate material (130) is provided in granular or powdered form, ensuring adequate packing density to enhance thermal dissipation and shock absorption.

6. The housing (100) according to any of the preceding claims, wherein the particulate material (130) substantially fills the compartment's (120) total volume to ensure optimal pressure and shock absorption, thermal dissipation, and electrical insulation.

7. The housing (100) according to any of the preceding claims, wherein the particulate material (130) is integrated with at least one water inlet (142) and at least one water outlet pipe (140) passing through the enclosure (110), one or more compartments (120), the inner wall (122) of the compartment (120) coated with an electrically insulating material (124), the outer wall (126) of the compartment (120) surrounded by a protective layer (128), and particulate material (130).

8. The housing (100) according to any of the preceding claims, wherein the particulate material (130) within the compartment (120) provides a variable gas permeability distribution towards the inner wall (122) of the compartment (120).

9. The housing (100) according to any of the preceding claims, wherein the insulating material (124) coating of the inner wall (122) is adapted to provide higher electrical insulation and thermal stability.

10. The housing (100) according to any of the preceding claims, wherein the protective layer (128) surrounding the outer wall (126) comprises a material that is compressible, heat resistant, resistant to oxidation and/or ozone, water, humidity, and possesses mechanical strength for enhancing the durability and functionality of the outer wall (126).

11. The housing (100) according to any of the preceding claims, wherein the housing (100) is of an arbitrary shape, and further comprises openings (160) for bushing arrangements or connectors to interface with external components.

12. The housing (100) according to claim 1, further comprising DC link capacitors (150) mounted outside the enclosure (110), or optionally between the enclosure (110) and the compartment (120).

13. The housing (100) according to claim 1, wherein the one or more compartments (120) enclose DC link capacitors (150) and directly connect them to DC buses (180) for integrated operation.

14. A power converter arrangement, comprising:
a housing (100) according to any of claims 1-13;
a converter cell housed within the compartment (120), wherein the converter cell is electrically isolated by the particulate material (130); and
a DC link capacitor (150) connected to the converter cell, wherein the DC link capacitor (150) is mounted either inside and/or outside the housing (100).

15. The power converter arrangement according to claim 14, wherein the converter cell is connected to a DC bus (180) through bushing arrangements or connectors provided in the openings (160) of the housing (100).
